(19) Europäisches Patentamt
European Patent Office
Office européen des brevets

(11) **EP 2 178 121 A1**

(12) **DEMANDE DE BREVET EUROPEEN**

(43) Date de publication:
**21.04.2010 Bulletin 2010/16**

(51) Int Cl.:
*H01L 27/02* (2006.01)   *H01L 45/00* (2006.01)

(21) Numéro de dépôt: **09172773.5**

(22) Date de dépôt: **12.10.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA RS**

(30) Priorité: **16.10.2008 FR 0857033**

(71) Demandeur: **COMMISSARIAT A L'ENERGIE ATOMIQUE**
**75015 Paris (FR)**

(72) Inventeur: **Nodin, Francois**
**38120, SAINT EGREVE (FR)**

(74) Mandataire: **Ilgart, Jean-Christophe**
**Brevalex**
**3, rue du Docteur Lancereaux**
**75008 Paris (FR)**

(54) **Procede de protection et de dissipation de decharges electrostatiques sur un circuit integre**

(57)     Dispositif de protection (100) d'au moins un circuit intégré contre une décharge électrostatique, comportant au moins :
- une portion de métal ionisable (106),
- un électrolyte solide (104) disposé contre la portion de métal ionisable et comprenant des ions métalliques de nature similaire au métal de ladite portion de métal ionisable,
- une électrode (102) reliée électriquement à l'électrolyte solide,
et dont la concentration en ions métalliques dans l'électrolyte solide est inférieure à la concentration de saturation des ions métalliques dans l'électrolyte solide.

FIG.2

EP 2 178 121 A1

**Description**

**DOMAINE TECHNIQUE**

L'invention concerne le domaine des circuits intégrés, et plus particulièrement celui de la protection de ces circuits intégrés contre les décharges électrostatiques (ESD pour « Electro Static Discharge ») pouvant apparaître sur des lignes de connexion de ces circuits intégrés.

**ÉTAT DE LA TECHNIQUE ANTÉRIEURE**

La majorité des composants électroniques actuels implantés dans des circuits intégrés sont à base de transistors MOS (« Metal-Oxyde-Semiconductor » en anglais). Dans ces transistors, des tensions de quelques volts supérieures à leur tension d'alimentation, qui sont typiquement comprises entre environ 3,3 V et 5 V, peuvent endommager l'oxyde de grille de ces transistors. Donc, plus la tension d'alimentation de ces composants est basse, plus la sensibilité de ces composants aux surtensions augmente.

Les valeurs des tensions de décharges électrostatiques (ESD) dans un environnement normal d'un circuit intégré peuvent atteindre généralement plusieurs dizaines de volts, voir plusieurs centaines de volts. Ces tensions peuvent-être destructives, même en présence de faibles charges dans le circuit intégré et donc de faibles courants traversant le circuit intégré lors de ces décharges.

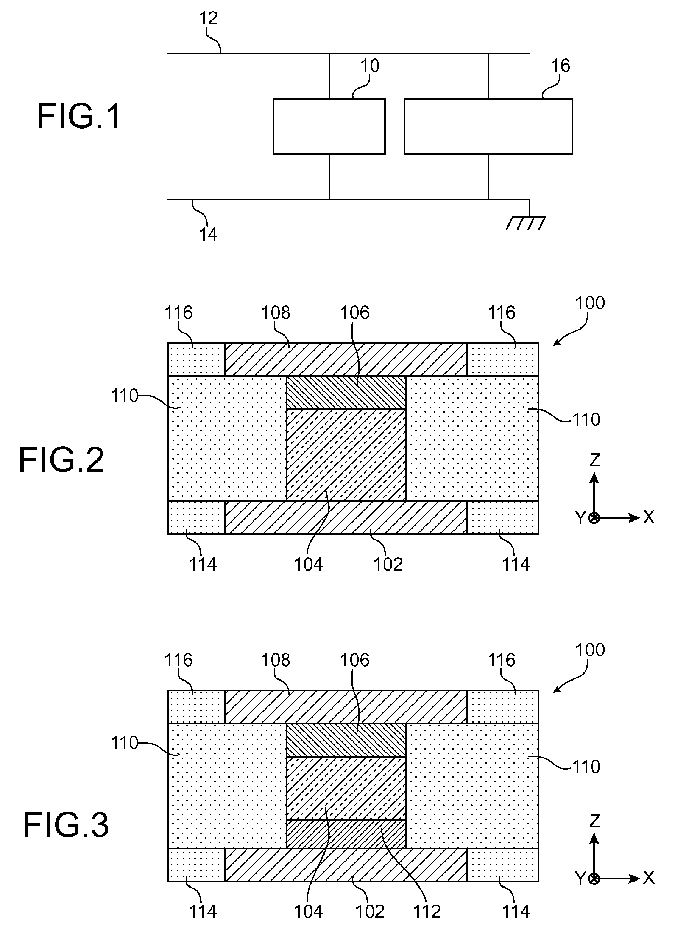

La figure 1 représente un exemple de configuration dans laquelle un dispositif de protection ESD 10 est disposé entre les entrées/sorties d'un circuit intégré 16 comportant par exemple des composants CMOS, ces entrées/sorties étant représentées par une ligne électrique d'entrée/sortie 12, et une masse 14. Le dispositif de protection ESD 10 permet d'évacuer les décharges électrostatiques ou surtensions apparaissant sur la ligne électrique d'entrée/sortie 12 directement vers la masse 14 sans que ces décharges passent à travers le circuit intégré 16, le protégeant ainsi de ces surtensions.

De tels dispositifs de protection ESD intégrés comportent généralement un assemblage de nombreux composants (diodes, transistors MOS & bipolaires, résistances,...). Le document US 7 242 558 B2 décrit par exemple un tel dispositif de protection ESD. Compte tenu du nombre important de composants nécessaires à sa réalisation, ce dispositif de protection est volumineux, ce qui est un inconvénient majeur lorsque celui-ci doit être intégré au circuit que l'on souhaite protéger. De plus, un tel dispositif de protection ESD comportant un nombre important de composants a pour inconvénient de présenter une capacité parasite importante limitant la bande passante du circuit intégré à protéger. Enfin, ce dispositif de protection ne fonctionne que si le circuit intégré à protéger est sous tension compte tenu de la nécessité d'alimenter au moins les transistors de ce dispositif.

Le document US 7 164 566 B2 décrit un autre type de dispositif de protection ESD. Le dispositif décrit dans ce document comporte une architecture complexe nécessitant de nombreuses étapes technologiques pour sa réalisation.

**EXPOSÉ DE L'INVENTION**

Un but de la présente invention est de proposer un dispositif de protection qui ne soit pas volumineux, nécessitant peu de composants et/ou comportant une architecture moins complexe que celles des dispositifs de l'art antérieur, permettant de protéger un circuit intégré lorsque celui-ci se trouve sous tension ou hors tension, et présentant une très faible capacité parasite vis-à-vis du circuit intégré à protéger.

Pour cela, la présente invention propose un dispositif de protection d'au moins un circuit intégré contre une décharge électrostatique, comportant au moins :

- une portion de métal ionisable,
- un électrolyte solide disposé contre la portion de métal ionisable et comprenant des ions métalliques de nature similaire au métal de ladite portion de métal ionisable,
- une électrode reliée électriquement à l'électrolyte solide,

et dont la concentration en ions métalliques dans l'électrolyte solide est inférieure à la concentration de saturation des ions métalliques dans l'électrolyte solide.

Un tel dispositif de protection permet de protéger efficacement un circuit intégré contre les décharges électrostatiques et ne nécessite pas de composants périphériques de polarisation. Ce dispositif de protection est également peu encombrant : typiquement, le diamètre du dispositif de protection peut être égal à environ 300 nm, et d'épaisseur inférieure à environ 100 nm en ce qui concerne la portion de métal ionisable et l'électrolyte solide. Un tel dispositif permet par exemple de dissiper un courant égale à environ 10 mA pendant une durée égale à environ 1 seconde.

Ce dispositif de protection présente également une très faible capacité parasite au circuit intégré protégé (par exemple inférieure à environ 100 fF), et a donc un faible impact sur la bande passante de fonctionnement du circuit intégré protégé.

Enfin, lorsque le dispositif de protection n'est pas soumis à une décharge électrostatique, celui-ci présente une très forte impédance (R > $10^9$ ohms), n'impliquant donc pas de courants de fuite ou de très faibles courants de fuite.

De manière avantageuse, le dispositif de protection peut comporter en outre une seconde électrode reliée électriquement à la portion de métal ionisable.

Avantageusement, la portion de métal ionisable peut être à base de cuivre et/ou d'argent, et/ou l'électrolyte solide peut être à base d'un chalcogénure, et/ou la ou les électrodes peuvent être à base de nickel et/ou de tungstène.

L'épaisseur de la ou des électrodes peut être comprise entre environ 100 nm et 300 nm, et/ou l'épaisseur de l'électrolyte solide peut être comprise entre environ 10 nm et 100 nm, et/ou l'épaisseur de la portion de métal ionisable peut être comprise entre environ 5 nm et 100 nm. Lorsque la couche de métal ionisable assure également le rôle de l'électrode (la seconde électrode est dans ce cas formée par la portion de métal ionisable elle-même), celle-ci peut avoir une épaisseur inférieure à environ 500 nm, et par exemple égale à environ 300 nm, ou encore comprise entre environ 300 nm et 500 nm.

Le dispositif de protection peut comporter en outre, lorsque le matériau de la ou des électrodes est apte à diffuser des ions dans l'électrolyte solide, une portion de matériau empêchant une diffusion ionique, formant une barrière de diffusion ionique, disposée entre la ou les électrodes et l'électrolyte solide.

Le dispositif de protection peut comporter en outre une portion de matériau résistif de conductivité inférieure à celle du matériau de la ou des électrodes, disposée entre l'électrode et la portion de métal ionisable, ou entre les électrodes. Une telle portion de matériau permet de limiter le courant maximal pouvant traverser le dispositif de protection.

Le dispositif de protection peut comporter en outre, lorsque le matériau de ladite portion de matériau résistif est apte à diffuser des ions dans l'électrolyte solide, une barrière de diffusion ionique disposée entre ladite portion de matériau et l'électrolyte solide.

Les éléments du dispositif de protection peuvent être entourés de portions de matériau électriquement isolant.

L'invention concerne également un procédé de protection d'au moins un circuit intégré contre une décharge électrostatique, comportant au moins la connexion électrique d'au moins un dispositif de protection tel que décrit plus haut, à une ligne électrique d'entrée et/ou de sortie du circuit intégré, l'une de l'électrode ou de la portion de métal ionisable du dispositif de protection étant reliée électriquement à la ligne électrique d'entrée et/ou de sortie du circuit intégré, l'autre étant reliée électriquement à une masse.

L'électrode ou la portion de métal ionisable reliée électriquement à la masse peut être reliée directement à la masse, ou être reliée à la masse par l'intermédiaire d'au moins un dispositif électronique tel qu'un filtre, une alimentation, un transformateur ou encore un coupleur.

Lorsque le dispositif de protection comporte une seconde électrode reliée électriquement à la portion de métal ionisable, la portion de métal ionisable peut être reliée électriquement à la ligne électrique d'entrée et/ou de sortie du circuit intégré ou à la masse par l'intermédiaire de la seconde électrode.

Le procédé peut comporter en outre la connexion et/ou le couplage électrique d'au moins un second dispositif de protection tel que décrit plus haut à la ligne électrique d'entrée et/ou de sortie du circuit intégré, et dans lequel, lorsque la portion de métal ionisable du premier dispositif de protection est reliée électriquement à la ligne électrique d'entrée et/ou de sortie du circuit intégré, l'électrode du second dispositif de protection peut être reliée électriquement à la ligne électrique d'entrée et/ou de sortie du circuit intégré et la portion de métal ionisable du second dispositif de protection peut être reliée électriquement à la masse, et lorsque la portion de métal ionisable du premier dispositif de protection est reliée électriquement à la masse, la portion de métal ionisable du second dispositif de protection peut être reliée électriquement à la ligne électrique d'entrée et/ou de sortie du circuit intégré et l'électrode du second dispositif de protection peut être reliée électriquement à la masse.

De préférence, lorsque le second dispositif de protection comporte une seconde électrode reliée électriquement à la portion de métal ionisable du second dispositif de protection, la portion de métal ionisable du second dispositif de protection peut être reliée électriquement à la ligne électrique d'entrée et/ou de sortie du circuit intégré ou à la masse par l'intermédiaire de la seconde électrode.

L'invention concerne également un procédé de dissipation d'une décharge électrostatique apparaissant sur au moins une ligne électrique d'entrée et/ou de sortie d'au moins un circuit intégré, comportant au moins les étapes de :

- transfert d'un courant issu de la décharge électrostatique dans un dispositif de protection tel que décrit précédemment par l'intermédiaire d'une électrode ou d'une portion de métal ionisable du dispositif de protection reliée électriquement à la ligne électrique d'entrée et/ou de sortie du circuit intégré ou à une masse,
- migration d'ions métalliques, issus de la portion de métal ionisable et diffusés dans un électrolyte solide du dispositif de protection disposé contre la portion de métal ionisable, dans l'électrolyte solide, abaissant la résistivité de l'ensemble formé par au moins la portion de métal ionisable et l'électrolyte solide, et formant un chemin conducteur entre l'électrode et la portion de métal ionisable,
- évacuation du courant issu de la décharge électrostatique à travers le dispositif de protection, par l'intermédiaire de l'électrode ou de la portion de métal ionisable reliée électriquement à la masse.

Lors de la migration des ions métalliques, la résistivité de l'ensemble formé par la portion de métal ionisable et l'électrolyte solide peut être abaissée d'une valeur $R_{HI}$ supérieure à environ $10^9$ ohms à une valeur $R_{BI}$ inférieure à environ $10^3$ ohms.

Le procédé de dissipation peut comporter en outre, après l'étape d'évacuation du courant issu de la décharge électrostatique, une étape de dispersion des ions métalliques ayant précédemment migré dans l'électrolyte solide, pouvant augmenter la résistivité de l'ensemble formé par la portion de métal ionisable et l'électrolyte solide.

Dans ce cas, lors de la dispersion des ions métalliques, la résistivité de l'ensemble formé par la portion de métal ionisable et l'électrolyte solide est augmentée d'une valeur $R_{BI}$ inférieure à environ $10^3$ ohms à une valeur $R_{HI}$ supérieure à environ $10^9$ ohms.

L'invention peut aussi concerner l'utilisation d'un dispositif semi-conducteur pour la protection d'au moins un circuit intégré contre une décharge électrostatique apparaissant sur au moins une ligne électrique d'entrée et/ou de sortie du circuit intégré, le dispositif semi-conducteur comportant au moins :

- une portion de métal ionisable,
- un électrolyte solide disposé contre la portion de métal ionisable et comprenant des ions métalliques issus de ladite portion de métal ionisable,
- une électrode reliée électriquement à l'électrolyte solide,

la concentration en ions métalliques dans l'électrolyte solide étant inférieure à la concentration de saturation des ions métalliques dans l'électrolyte solide,
l'une de l'électrode ou de la portion de métal ionisable étant reliée électriquement à la ligne électrique d'entrée et/ou de sortie du circuit intégré, l'autre étant reliée électriquement à une masse.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- la figure 1 représente une configuration de protection d'un circuit intégré par un dispositif de protection ESD selon l'art antérieur,
- la figure 2 représente un dispositif de protection selon un premier mode de réalisation utilisé pour la protection d'un circuit intégré contre les décharges électrostatiques,
- la figure 3 représente un dispositif de protection selon un second mode de réalisation utilisé pour la protection d'un circuit intégré contre les décharges électrostatiques,
- la figure 4 représente graphiquement la variation de la conductivité du dispositif de protection selon le premier ou le second mode de réalisation en fonction de la valeur de la tension appliquée entre les électrodes de ce dispositif de protection,
- la figure 5 représente une configuration dans laquelle un circuit intégré est protégé par deux dispositifs de protection,
- la figure 6 représente une configuration dans laquelle un circuit intégré est protégé par six dispositifs de protection.

Des parties identiques, similaires ou équivalentes des différentes figures décrites ci-après portent les mêmes références numériques de façon à faciliter le passage d'une figure à l'autre.
Les différentes parties représentées sur les figures ne le sont pas nécessairement selon une échelle uniforme, pour rendre les figures plus lisibles.
Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

On se réfère tout d'abord à la figure 2 qui représente un dispositif de protection 100 selon un premier mode de réalisation utilisé pour la protection d'un circuit intégré contre des décharges électrostatiques.
Ce dispositif 100 comporte une électrode inférieure 102 à base d'un matériau conducteur, par exemple à base d'un métal inerte tel que du tungstène et/ou du nickel, sur laquelle est disposé un électrolyte solide 104, par exemple à base de chalcogénure, dopé ou non, tel que du GeSe, et/ou du GeS et/ou du $WO_x$ et/ou à base de tellure. L'électrode inférieure 102 a par exemple une épaisseur comprise entre environ 100 nm et 300 nm. L'électrolyte solide 104 a par exemple une épaisseur comprise entre environ 10 nm et 100 nm. Dans le cas où le matériau de l'électrode inférieure 102 est apte à diffuser des ions dans l'électrolyte solide 104 (on parle alors d'électrode « soluble »), une barrière de diffusion ionique peut être disposée entre l'électrode inférieure 102 et l'électrolyte solide 104. Une telle barrière de diffusion ionique est par exemple formée par une portion de Wn et/ou de TiN et/ou de tout autre matériau adapté pour empêcher une diffusion d'ions dans l'électrolyte solide 104 depuis l'électrode inférieure 102. L'épaisseur de cette barrière ionique est par exemple comprise entre environ 10 nm et 20 nm.
Une portion de métal ionisable 106, ou métal actif, par exemple à base d'argent et/ou de cuivre, est disposée sur l'électrolyte solide 104. Ce métal est qualifié de ionisable car lors de son dépôt sur l'électrolyte solide 104 ou d'une étape de diffusion thermique ou par rayonnement, ce métal diffuse des ions métalliques dans l'électrolyte solide 104. Une électrode supérieure 108 à base d'un matériau conducteur, par exemple à base d'un métal inerte tel que du tungstène et/ou du nickel, est disposée sur la portion de métal ionisable 106. L'épaisseur de l'électrode supérieure 108 est par exemple comprise entre environ 100 nm et 300 nm. Dans le cas où le matériau de l'électrode supérieure 108 est apte à diffuser des ions dans l'électrolyte solide 104, une barrière de diffusion, par exemple similaire à celle décrite précédemment, peut être disposée entre l'électrode supérieure 108 et la portion de métal ionisable 106.

L'électrolyte solide 104 comporte des ions métalliques de nature similaire au métal de la portion de métal ionisable 106, issus de la portion de métal ionisable 106. Ces ions métalliques ont migré depuis la portion de métal ionisable 106 dans l'électrolyte solide 104 lors du dépôt de la portion de métal ionisable 106 sur l'électrolyte solide 104, et/ou éventuellement après une étape de diffusion ultérieure (par exemple par un traitement thermique ou par un rayonnement UV). Dans une variante, les ions métalliques peuvent être intégrés dans l'électrolyte solide 104 directement lors du dépôt de cet électrolyte solide 104, par exemple par co-pulvérisation de l'électrolyte solide 104 et du métal ionisable 106.

La concentration en ions métalliques dans l'électrolyte solide 104 est inférieure à la concentration de saturation en ions métalliques du matériau de l'électrolyte solide 104 et est de manière générale par exemple comprise entre environ 5% et 50%. La valeur de la concentration de saturation en ions métalliques dans l'électrolyte solide 104 est fonction de la nature des ions métalliques, ainsi que de la nature du matériau de l'électrolyte solide. Par exemple, dans le cas d'un électrolyte solide 104 à base de GeSe et d'une portion de métal ionisable 106 à base d'Ag, la concentration de saturation en ion argent dans l'électrolyte solide 104 est égale à environ 30%. On choisira donc ici une concentration en ion argent, dans le GeSe, inférieure à environ 30%.

L'électrode inférieure 102, l'ensemble formé par l'électrolyte solide 104 et la portion de métal ionisable 106, et l'électrode supérieure 108 sont respectivement entourés par des portions diélectriques 110, 114 et 116 destinées à isoler thermiquement et électriquement le dispositif de protection 100. Ces portions diélectriques sont par exemple à base de $SiO_2$ et/ou de $Si_3N_4$.

Un tel dispositif 100 présente de faibles dimensions : par exemple, l'épaisseur totale de l'électrolyte solide 104 et de la portion de métal ionisable 106 peut être égale à environ 65 nm, formant un dispositif de protection 100 d'épaisseur égale à environ 265 nm lorsque les électrodes ont chacune une épaisseur égale à environ 100 nm. Le diamètre du dispositif de protection 100 est par exemple égal à environ 300 nm.

La figure 3 représente le dispositif de protection 100 selon un second mode de réalisation. Par rapport au premier mode de réalisation précédemment décrit, le dispositif de protection 100 selon le second mode de réalisation comporte en outre une portion de matériau résistif 112 disposée entre l'électrode inférieure 102 et l'électrolyte solide 104. Dans une variante de ce second mode de réalisation, cette portion de matériau résistif 112 pourrait également être disposée entre l'électrode supérieure 108 et la portion de métal ionisable 106. Le matériau résistif de cette portion 112 est choisi tel qu'il présente une conductivité inférieure à celle du matériau de l'électrode inférieure 102 et/ou de l'électrode supérieure 108, formant ainsi une résistance série à l'intérieur du dispositif 100 entre l'électrode inférieure 102 et l'électrode supérieure 108, et permettant de limiter le courant traversant le dispositif de protection 100 entre les électrodes 102 et 108 et donc de protéger le dispositif 100 d'une éventuelle destruction si celui-ci était soumis à une décharge ESD trop importante. Les dimensions de cette portion de matériau résistif 112 sont choisies en fonction de la résistance souhaitée et de la résistivité du matériau de cette portion résistive 112.

Le courant maximal que peut supporter le dispositif de protection 100 est déterminé expérimentalement et la résistance destinée à être présentée par le dispositif de protection 100 est calculée à partir de la valeur de ce courant maximal et des paramètres liés au dispositif à protéger, tel que la durée maximale pendant laquelle le dispositif à protéger peut être traversé par le courant, ou encore la tension crête maximale supportable par le dispositif à protéger. Le matériau de cette portion résistive 112 peut être choisi pour qu'il ne diffuse pas d'ions dans l'électrolyte solide 104. Dans le cas où le matériau de cette portion 112 est apte à diffuser des ions dans l'électrolyte solide 104, une barrière de diffusion, par exemple similaire à celles précédemment décrites, peut être disposée entre cette portion de matériau résistif 112 et l'électrolyte solide 104.

Le dispositif 100 présente, entre ses deux électrodes 102 et 108, une conductivité dont la valeur est globalement définie par la conductivité de l'ensemble formé par l'électrolyte solide 104 et la portion de métal ionisable 106, et éventuellement de la portion résistive 112. Or, la conductivité de cet ensemble dépend de la tension appliquée à ses bornes, c'est-à-dire de la tension appliquée entre les électrodes 102 et 108.

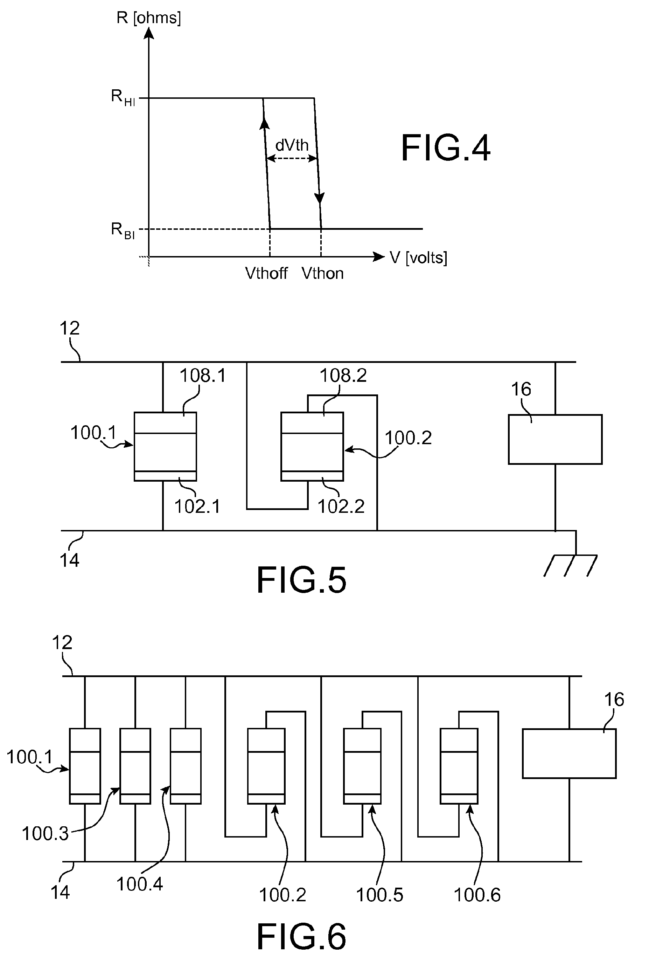

La figure 4 représente graphiquement la variation de cette conductivité (en ohms) en fonction de la valeur de la tension (en volts) appliquée entre les électrodes 102 et 108. Le dispositif 100 présente un premier état stable haute impédance $R_{HI}$ (avec par exemple $R_{HI} > 10^9$ ohms, ou encore $10^6 < R_{HI} < 10^9$ ohms), et un second état basse impédance $R_{BI}$ (avec par exemple $R_{BI} < 10^3$ ohms, ou encore $10 < R_{BI} < 10^3$ ohms) se déclenchant lorsque la tension entre les électrodes 102, 108 dépasse une tension de seuil $V_{thon}$, par exemple comprise entre environ 500 mV et 5 V. De préférence, on choisira une tension de seuil $V_{thon}$ s'approchant le plus possible de la tension limite de claquage des matériaux utilisés dans le dispositif de protection 100. Le retour de l'état basse impédance $R_{BI}$ à l'état haute impédance $R_{HI}$ se fait automatiquement lorsque la valeur de la tension entre les électrodes 102, 108 repasse en-dessous d'un seuil $V_{thoff}$, par exemple comprise entre environ 200 mV et 2V, et de valeur inférieure à la valeur de la tension de seuil $V_{thon}$. Sur la figure 4, on voit que la valeur de $V_{thoff}$ est inférieure à celle de $V_{thon}$, formant une hystérésis $dV_{th}$.

Lors de l'apparition d'une décharge ESD, la tension aux bornes des électrodes 102 et 108 du dispositif 100 dépasse la tension de seuil $V_{thon}$. Les ions métalli-

ques se trouvant dans l'électrolyte solide 104 forment alors un chemin de conduction dans l'électrolyte 104 par un phénomène de migration, provoquant le passage de la conductivité du dispositif 100 du premier état haute impédance $R_{HI}$ au second état basse impédance $R_{BI}$. La décharge ESD peut ainsi être évacuée à travers le dispositif de protection 100. Lorsque la décharge ESD est terminée, la tension entre les électrodes 102, 108 chute, repassant en-dessous du seuil $V_{thoff}$ et entraînant la suppression du chemin de conduction précédemment formé dans l'électrolyte 104 par la dispersion des ions métalliques ayant précédemment migré dans l'électrolyte 104. Le dispositif de protection 100 revient alors automatiquement à l'état stable haute impédance $R_{HI}$.

Plusieurs paramètres du dispositif de protection 100 permettent de modifier les tensions de commutation $V_{thon}$, $V_{thoff}$ et l'hystérésis $dV_{th}$ :

- la nature du métal ionisable 106,
- la nature du matériau de l'électrolyte solide 104,
- la quantité d'ions métalliques diffusés dans l'électrolyte solide 104,
- le coefficient de diffusion du métal ionisable 106,
- l'ajout de dopants dans l'électrolyte solide 104.

La figure 5 représente un exemple de configuration dans laquelle un circuit intégré 16 est protégé des décharges électrostatiques. Par analogie avec la configuration représentée sur la figure 1, le circuit intégré 16 à protéger comporte une ligne d'entrée et/ou de sortie 12 et une ligne 14 reliée à la masse. Un premier dispositif de protection 100.1 tel que précédemment décrit selon le premier ou le second mode de réalisation est relié en parallèle au circuit intégré 16, entre la ligne d'entrée/sortie 12 et la masse 14, en amont du circuit intégré 16. Un second dispositif de protection 100.2 est également relié en parallèle au circuit intégré 16, entre la ligne d'entrée/sortie 12 et la masse 14, et également en amont du circuit intégré 16. L'électrode supérieure 108.1 du premier dispositif de protection 100.1 est reliée électriquement à la ligne d'entrée/sortie 12, l'électrode inférieure 102.1 du premier dispositif de protection 100.1 étant reliée électriquement à la masse 14. Inversement, l'électrode supérieure 108.2 du second dispositif de protection 100.2 est reliée électriquement à la masse 14 et l'électrode inférieure 102.2 du second dispositif de protection 100.2 est reliée électriquement à la ligne d'entrée/sortie 12.

Ainsi, étant donné que chacun des dispositifs de protection 100.1 et 100.2 a un fonctionnement unipolaire (passage de l'état haute impédance $R_{HI}$ à l'état basse impédance $R_{BI}$ en présence d'une tension positive entre l'électrode inférieure 102 et l'électrode supérieure 108), ce couplage permet de réaliser une protection bipolaire du circuit intégré 16, le protégeant de décharges ESD de valeur indifféremment positive ou négative apparaissant sur la ligne d'entrée/sortie 12. Toutefois, si l'on souhaite réaliser une protection unipolaire du circuit intégré 16, il est possible de ne relier qu'un seul dispositif de protection 100 entre la ligne d'entrée/sortie 12 et la masse 14, en parallèle et en amont du circuit intégré 16 à protéger. Dans ce cas, le dispositif de protection sera relié comme le premier dispositif 100.1 ou comme le second dispositif 100.2 selon le type de décharges électrostatiques dont doit être protégé le circuit intégré 16.

Etant donné que les dimensions du dispositif de protection 100 sont faibles, celui-ci peut supporter d'être traversé par un courant de valeur maximale $I_{max}$. Si un circuit intégré doit être protégé de décharges ESD impliquant des courants de valeurs supérieures à $I_{max}$, il est dans ce cas possible d'utiliser plusieurs dispositifs de protection 100 reliés en parallèle les uns aux autres. La figure 6 représente un exemple d'une telle configuration dans laquelle six dispositifs de protection 100.1 à 100.6 sont reliés en parallèle au circuit intégré 16, entre la ligne d'entrée/sortie 12 et la masse 14, en amont du circuit intégré 16. Parmi ces six dispositifs de protection 100.1 à 100.6, trois premiers dispositifs de protection 100.1 à 100.3 comportent leurs électrodes supérieures reliées à la ligne d'entrée/sortie 12 et leurs électrodes inférieures reliées à la masse 14, trois seconds dispositifs de protection 100.4 à 100.6 comportant leurs électrodes supérieures reliées à la masse 14 et leurs électrodes inférieures reliées à la ligne d'entrée/sortie 12. On obtient ainsi une protection bipolaire du dispositif CMOS 16 réalisée par six dispositifs de protection 100, permettant ainsi de supporter de forts courants de décharges électrostatiques, le courant de décharge étant régulièrement réparti entre trois des dispositifs de protection 100 selon le signe de la surtension électrostatique.

L'exemple de la figure 6 peut être généralisé : un circuit intégré 16 peut être protégé par N dispositifs de protection 100, avec N nombre entier strictement positif. De plus, dans le cas d'une protection bipolaire, une partie des N dispositifs de protection peuvent être reliés de manière inversée au circuit intégré 16 par rapport aux autres dispositifs de protection, de manière analogue à la configuration précédemment décrite en liaison avec la figure 6. De plus, le nombre de dispositifs de protection reliés de manière inversée entre la ligne d'entrée/sortie et la masse n'est pas nécessairement égal au nombre de dispositifs de protection reliés de manière non inversée entre la ligne d'entrée/sortie et la masse.

On décrit maintenant un procédé de réalisation du dispositif de protection 100 précédemment décrit.

L'électrode inférieure 102 est tout d'abord réalisée en déposant une couche de matériau conducteur destinée à former cette électrode inférieure 102, par exemple par pulvérisation, dépôt CVD (dépôt chimique en phase vapeur), PECVD (dépôt chimique en phase vapeur assisté par plasma), évaporation ou toute autre technique de dépôt adaptée, sur un substrat semi-conducteur, par exemple à base de silicium, de germanium, ou encore d'AsGa, ou encore de type SOI, non représenté. Ce substrat peut également être à base d'un matériau organique, le substrat étant dans ce cas isolant électriquement. Il est également possible que ce matériau conducteur soit déposé sur une couche métallique elle-même disposée sur le substrat et destinée à former une connexion électrique avec d'autres éléments réalisés sur le substrat et/ou les lignes de connexions du ou des circuits intégrés à protéger. La couche de matériau conducteur déposée est ensuite gravée pour former l'électrode inférieure 102 selon les dimensions et la forme voulues. Les dimensions de la section de l'électrode inférieure 102 qui est destinée à être traversée par les courants des décharges électrostatiques seront choisies en fonction de la valeur du courant maximum destiné à traverser le dispositif de protection 100. Cette électrode inférieure peut par exemple avoir des côtés de dimensions égales à environ 1 $\mu$m, et une épaisseur égale à environ 300 nm.

Les portions diélectriques 114 sont ensuite formées autour de l'électrode inférieure 102 par dépôt d'un matériau diélectrique et planarisation avec arrêt sur l'électrode inférieure 102.

Dans l'exemple du second mode de réalisation, une couche de matériau résistif est ensuite déposée sur l'électrode inférieure 102 et sur les portions diélectriques 114, puis gravée afin de former la portion résistive 112. Dans le cas du premier mode de réalisation, ces étapes de réalisation de la portion résistive 112 sont omises.

Une couche de matériau destiné à former l'électrolyte solide 104, par exemple de chalcogénure, est ensuite déposée sur la portion résistive 112 ou sur l'électrode inférieure 102, ainsi que sur les portions diélectriques. Une couche du métal ionisable, par exemple à base de cuivre et/ou de tungstène, destinée à former la portion de métal ionisable 106 étant ensuite déposée sur la couche de matériau de l'électrolyte solide 104. Des ions métalliques issus de la couche de métal ionisable 106 se diffusent dans la couche de matériau de chalcogénure destinée à former l'électrolyte solide 104 lors du dépôt du métal ionisable 106 sur la couche de l'électrolyte solide 104. Ces couches (destinées à former l'électrolyte solide 104 et la portion de métal ionisable 106), et éventuellement le matériau résistif 112, sont ensuite gravées selon les dimensions souhaitées pour former l'électrolyte solide 104 et la portion de métal ionisable 106. Si certains des matériaux utilisés (hormis le matériau actif 106) sont aptes à diffuser des ions dans l'électrolyte solide 104, il est possible de mettre en oeuvre des étapes de réalisation de barrières de diffusion entre l'électrolyte 104 et ces matériaux, en déposant par exemple des couches de matériaux appropriés entre les éléments en question et l'électrolyte solide 104 et en les gravant aux dimensions souhaitées.

Il est également possible de mettre en oeuvre une étape de dopage de l'électrolyte solide 104, par exemple lorsque ce matériau n'est pas intrinsèquement dopé, par exemple par une diffusion thermique de dopants issus d'une couche de dopants préalablement déposée sur l'électrolyte solide 104 et dont les dopants s'auto-diffusent lors du dépôt, ou par une insolation UV ou un traitement thermique supplémentaire. De plus, il est également possible d'augmenter la concentration en ions métalliques dans l'électrolyte solide 104 par une étape supplémentaire de diffusion pouvant consister en un traitement thermique ou un rayonnement UV réalisé sur la portion de métal ionisable 106 et l'électrolyte solide 104.

La quantité d'ions métallique diffusés dans l'électrolyte solide est choisie telle que la concentration en ions métalliques dans l'électrolyte solide soit inférieure à la valeur de la concentration de saturation de ces ions dans l'électrolyte solide. Lorsque cette valeur de la concentration de saturation est inconnue, la valeur de la concentration en ions métalliques dans l'électrolyte solide à réaliser peut être obtenue en mettant en oeuvre les essais successifs suivants :

- on choisit tout d'abord une concentration initiale en ions métalliques dans l'électrolyte solide,
- on mesure la tension de commutation $V_{THon}$,
- si $V_{THon}$ > tension de destruction du dispositif à protéger, on augmente alors la concentration en ions métallique dans l'électrolyte solide afin d'abaisser la valeur de $V_{THon}$ et ceci jusqu'à obtenir $V_{THon}$ < tension de destruction du dispositif à protéger (tout en ayant $V_{THon}$ > tension de fonctionnement (ou d'alimentation) du dispositif de protection). Lorsque la concentration obtenue permet d'avoir $V_{THon}$ < tension de destruction du dispositif à protéger, on vérifie si on a bien $V_{THoff}$ > 0. Si ces conditions sont vérifiées, alors la concentration en ions métalliques dans l'électrolyte solide est donc bien inférieure à la concentration de saturation,
- si $V_{THon}$ < tension de fonctionnement (ou d'alimentation) du dispositif de protection, on réduit alors la concentration en ions métalliques jusqu'à avoir $V_{THon}$ > tension de fonctionnement (ou d'alimentation) du dispositif de protection (tout en ayant $V_{THon}$ < tension de destruction du dispositif à protéger). On vérifie également si l'on a bien $V_{THoff}$ > 0. Si ces conditions sont vérifiées, alors la concentration en ions métalliques dans l'électrolyte solide est donc bien inférieure à la concentration de saturation.

Des portions diélectriques 110 sont ensuite réalisées par dépôt et planarisation autour des éléments 112, 104 et 106. Enfin, l'électrode supérieure 108 ainsi que les portions diélectriques 116 sont réalisées, par exemple de manière similaire à l'électrode inférieure 102 et aux portions diélectriques 114.

De manière générale, les matériaux utilisés pour réaliser les différents éléments du dispositif de protection 100 pourront être déposés par pulvérisation, dépôt CVD (dépôt chimique en phase vapeur), évaporation ou toute autre technique de dépôt adaptée, et gravure et/ou planarisation par exemple mécano-chimique (CMP).

L'épaisseur de l'électrolyte solide 104 réalisée est calculée notamment en fonction de la nature du matériau formant l'électrolyte (par exemple un chalcogénure dopé), de la valeur de la résistance à l'état haute impédance $R_{HI}$ (cette valeur de résistance étant proportionnelle à l'épaisseur de matériau selon la relation

$$R = \frac{\sigma \cdot e}{S} \, , \text{ avec } e \text{ épaisseur du matériau, } \sigma \text{ résistivité}$$

du matériau , et S surface du matériau en contact avec le métal ionisable), de la géométrie du matériau (notamment de la surface S) et de la tension de claquage du matériau (le champ électrique de claquage étant supérieur à la tension de commutation du dispositif).

L'épaisseur de la portion de métal ionisable 106 est déterminée en fonction du matériau des électrodes 102, 108, du type de dissolution dans l'électrolyte (diffusion spontanée et/ou diffusion stimulée par un dopage UV ou un traitement thermique du métal ionisable 106), de la tension de commutation $V_{thon}$ souhaitée et de l'épaisseur de l'électrolyte solide 104. L'épaisseur de la portion de métal ionisable 106 peut par exemple être comprise entre environ 5 nm et 100 nm.

De plus, la concentration en ions métalliques issus de la portion de métal ionisable 106 dans l'électrolyte solide 104 peut être ajustée pour obtenir la tension de commutation désirée. Cette tension de commutation est choisie de préférence inférieure à une tension de saturation pour garantir un retour à l'état haute impédance spontané. Cet ajustement peut être obtenu en choisissant une épaisseur adéquate de la portion de métal ionisable 106, cette épaisseur optimale pouvant être déterminée par différents essais expérimentaux.

Dans les exemples représentés sur les figures 2 et 3, l'électrode inférieure 102 et l'électrode supérieure 108 ont des dimensions supérieures à celles des éléments 112, 104 et 106 dans un plan (x,y) (selon les axes x, y et z représentés sur les figures 2 et 3). Ainsi, la surface de la zone active du dispositif de protection 100 (cette surface correspondant à celle qui traversée par un courant lors de la dissipation de décharges électrostatiques) est définie par la surface de l'électrolyte solide 104 dans le plan (x,y), cette surface étant similaire à la surface de la portion de métal ionisable 106 dans ce même plan. Cette surface est par exemple comprise entre environ 700 nm$^2$ à 0,07 $\mu$m$^2$.

Dans une variante, il est possible d'avoir des électrodes présentant des dimensions inférieures à celles des éléments 112, 104 et 106 dans le plan (x,y). La surface de la zone active du dispositif de protection 100 est alors déterminée par les dimensions des électrodes 102, 108 dans le plan (x,y).

**Revendications**

1. Dispositif de protection (100, 100.1 - 100.6) d'au moins un circuit intégré (16) contre une décharge électrostatique, comportant au moins :

- une portion de métal ionisable (106),
- un électrolyte solide (104) disposé contre la portion de métal ionisable (106) et comprenant des ions métalliques de nature similaire au métal de ladite portion de métal ionisable (106),
- une électrode (102, 102.1) reliée électriquement à l'électrolyte solide (104),

et dont la concentration en ions métalliques dans l'électrolyte solide (104) est inférieure à la concentration de saturation des ions métalliques dans l'électrolyte solide (104).

2. Dispositif de protection (100, 100.1 - 100.6) selon la revendication 1, comportant en outre une seconde électrode (108, 108.1) reliée électriquement à la portion de métal ionisable (106).

3. Dispositif de protection (100, 100.1 - 100.6) selon l'une des revendications précédentes, dans lequel la portion de métal ionisable (106) est à base de cuivre et/ou d'argent, et/ou l'électrolyte solide (104) est à base d'un chalcogénure, et/ou la ou les électrodes (102, 108) sont à base de nickel et/ou de tungstène.

4. Dispositif de protection (100, 100.1 - 100.6) selon l'une des revendications précédentes, dans lequel l'épaisseur de la ou des électrodes (102, 108) est comprise entre environ 100 nm et 300 nm, et/ou l'épaisseur de l'électrolyte solide (104) est comprise entre environ 10 nm et 100 nm, et/ou l'épaisseur de la portion de métal ionisable (106) est comprise entre environ 5 nm et 100 nm.

5. Dispositif de protection (100, 100.1 - 100.6) selon l'une des revendications précédentes, comportant en outre, lorsque le matériau de la ou des électrodes (102, 108) est apte à diffuser des ions dans l'électrolyte solide (104), une barrière de diffusion ionique disposée entre la ou les électrodes (102, 108) et l'électrolyte solide (104).

6. Dispositif de protection (100, 100.1 - 100.6) selon l'une des revendications précédentes, comportant en outre une portion (112) de matériau résistif de conductivité inférieure à celle du matériau de la ou des électrodes (102, 108), disposée entre l'électrode (102) et la portion de métal ionisable (106), ou entre les électrodes (102, 108).

7. Dispositif de protection (100, 100.1 - 100.6) selon la revendication 6, comportant en outre, lorsque le matériau de ladite portion (112) de matériau résistif est apte à diffuser des ions dans l'électrolyte solide (104), une barrière de diffusion ionique disposée entre ladite portion de matériau (112) et l'électrolyte solide (104).

**8.** Dispositif de protection (100, 100.1 - 100.6) selon l'une des revendications précédentes, dont les éléments sont entourés de portions de matériau électriquement isolant (110, 114, 116).

**9.** Procédé de protection d'au moins un circuit intégré (16) contre une décharge électrostatique, comportant au moins la connexion électrique d'au moins un dispositif de protection (100, 100.1, 100.3, 100.4) selon l'une des revendications 1 à 8 à une ligne électrique d'entrée et/ou de sortie (12) du circuit intégré (16), l'une de l'électrode (102) ou de la portion de métal ionisable (106) du dispositif de protection (100, 100.1, 100.3, 100.4) étant reliée électriquement à la ligne électrique d'entrée et/ou de sortie (12) du circuit intégré (16), l'autre étant reliée électriquement à une masse (14).

**10.** Procédé de protection selon la revendication 9, dans lequel, lorsque le dispositif de protection (100, 100.1, 100.3, 100.4) comporte une seconde électrode (108, 108.1) reliée électriquement à la portion de métal ionisable (106), la portion de métal ionisable (106) est reliée électriquement à la ligne électrique d'entrée et/ou de sortie (12) du circuit intégré (16) ou à la masse (14) par l'intermédiaire de la seconde électrode (108, 108.1).

**11.** Procédé de protection selon l'une des revendications 9 ou 10, comportant en outre la connexion électrique d'au moins un second dispositif de protection (100, 100.2, 100.5, 100.6) selon l'une des revendications 1 à 8, à la ligne électrique d'entrée et/ou de sortie (12) du circuit intégré (16), et dans lequel, lorsque la portion de métal ionisable (106) du premier dispositif de protection (100, 100.1, 100.3, 100.4) est reliée électriquement à la ligne électrique d'entrée et/ou de sortie (12) du circuit intégré (16), l'électrode (102, 102.2) du second dispositif de protection (100, 100.2, 100.5, 100.6) est reliée électriquement à la ligne électrique d'entrée et/ou de sortie (12) du circuit intégré (16) et la portion de métal ionisable (106) du second dispositif de protection (100, 100.2, 100.5, 100.6) est reliée électriquement à la masse (14), et lorsque la portion de métal ionisable (106) du premier dispositif de protection (100) est reliée électriquement à la masse (14), la portion de métal ionisable (106) du second dispositif de protection (100) est reliée électriquement à la ligne électrique d'entrée et/ou de sortie (12) du circuit intégré (16) et l'électrode (102) du second dispositif de protection (100) est reliée électriquement à la masse (14).

**12.** Procédé de protection selon la revendication 11, dans lequel, lorsque le second dispositif de protection (100, 100.2, 100.5, 100.6) comporte une seconde électrode (108, 108.2) reliée électriquement à la portion de métal ionisable (106) du second dispositif de protection (100, 100.2, 100.5, 100.6), la portion de métal ionisable (106) du second dispositif de protection (100, 100.2, 100.5, 100.6) est reliée électriquement à la ligne électrique d'entrée et/ou de sortie (12) du circuit intégré (16) ou à la masse (14) par l'intermédiaire de la seconde électrode (108, 108.2).

FIG.1

FIG.2

FIG.3

FIG.4

FIG.5

FIG.6

Europäisches
Patentamt

European
Patent Office

Office européen
des brevets

# RAPPORT DE RECHERCHE EUROPEENNE

Numéro de la demande

EP 09 17 2773

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 1 873 758 A (HITACHI GLOBAL STORAGE TECH [NL]) 2 janvier 2008 (2008-01-02) * abrégé * * alinéas [0046], [0047], [0050] - [0055], [0058] * * figures 17,19 * | 1-12 | INV. H01L27/02 H01L45/00 |
| X | EP 0 261 938 A (RAYCHEM LTD [GB]) 30 mars 1988 (1988-03-30) * abrégé * * page 2, ligne 36 - page 3, ligne 41 * * page 6, ligne 37 - ligne 54 * | 1-12 | |
| A | US 2007/200155 A1 (RABERG WOLFGANG [FR] ET AL) 30 août 2007 (2007-08-30) * abrégé * * alinéas [0030] - [0035] * | 1-12 | |
| A | KOZICKI M N ET AL: "Mass transport in chalcogenide electrolyte films - materials and applications" JOURNAL OF NON-CRYSTALLINE SOLIDS, NORTH-HOLLAND PHYSICS PUBLISHING. AMSTERDAM, NL, vol. 352, no. 6-7, 15 mai 2006 (2006-05-15), pages 567-577, XP025187128 ISSN: 0022-3093 [extrait le 2006-05-15] * le document en entier * | 1-12 | DOMAINES TECHNIQUES RECHERCHES (IPC) H01L H01C |
| A | US 3 343 085 A (OVSHINSKY STANFORD R) 19 septembre 1967 (1967-09-19) * le document en entier * | 1-12 | |

Le présent rapport a été établi pour toutes les revendications

| Lieu de la recherche | Date d'achèvement de la recherche | Examinateur |
|---|---|---|
| Berlin | 6 novembre 2009 | Morena, Enrico |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 2 178 121 A1**

**ANNEXE AU RAPPORT DE RECHERCHE EUROPEENNE
RELATIF A LA DEMANDE DE BREVET EUROPEEN NO.**

EP 09 17 2773

06-11-2009

| Document brevet cité au rapport de recherche | | Date de publication | Membre(s) de la famille de brevet(s) | | Date de publication |
|---|---|---|---|---|---|
| EP 1873758 | A | 02-01-2008 | CN | 101097720 A | 02-01-2008 |
| | | | JP | 2008010138 A | 17-01-2008 |
| | | | US | 2008037182 A1 | 14-02-2008 |
| EP 0261938 | A | 30-03-1988 | JP | 63102302 A | 07-05-1988 |
| | | | US | 4887182 A | 12-12-1989 |
| US 2007200155 | A1 | 30-08-2007 | AUCUN | | |
| US 3343085 | A | 19-09-1967 | AUCUN | | |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7242558 B2
- US 7164566 B2